# EUROPEAN PATENT APPLICATION

(11) **EP 1 792 874 A1**
(43) Date of publication of application: **06.06.2007**
(21) Application number: 05770377.9
(22) Date of filing: 09.08.2005
(51) Int. Cl.: C01B 33/113, C23C 14/24

(54) **SiO DEPOSITION MATERIAL, Si POWDER FOR SiO RAW MATERIAL, AND METHOD FOR PRODUCING SiO**

(30) Priority: 01.09.2004 JP 2004253733
(71) Applicant: Sumitomo Titanium Corporation, Amagasaki-shi, Hyogo 660-8533 (JP)
(72) Inventor: KIZAKI, Shingo, cho, Amagasaki-shi, Hyogo 6608533; (JP); NISHIOKA, Kazuo, cho, Amagasaki-shi, Hyogo 6608533; (JP)
(74) Representative: Simons, Amanda Louise
(86) International application number: PCT/JP2005/014552
(87) International publication number: WO 2006/025194

(57) **Abstract**

A silicon monoxide or a silicon monoxide vapor deposition material is **characterized in that** a hydrogen gas content is not lower than 120 ppm, and a silicon monoxide vapor deposition material is **characterized in that** the hydrogen gas content is not lower than 150 ppm. A film deposition rate is increased when the silicon monoxide is deposited on a substrate, so that a silicon monoxide deposited film can efficiently be formed. A sublimation rate can be increased in producing the silicon monoxide by setting the hydrogen gas content of the raw material silicon powders to 30 ppm or more, so that the silicon monoxide can efficiently be produced at low cost. Therefore, the silicon monoxide producing method of the present invention can widely be applied as a method for producing vapor deposition materials for packaging materials having transparency and barrier properties which are used for foods, medical products, medicinal products, and the like or vapor deposition materials for lithium battery electrode materials having silicon monoxide deposited films.

## Description

### Technical Field

The present invention relates to a silicon monoxide vapor deposition material used to produce a silicon monoxide vapor-deposited film which can be applied not only to packaging materials having transparency and barrier properties in the fields such as foods, medical products, and medicinal products but also to lithium battery electrode materials, a method for producing the silicon monoxide, and a Si raw material for producing the silicon monoxide.

### Background Art

Usually, in the case where foods and the like are packaged in the field of the food processing industry, oxygen, hydrogen, aromatic gas, and the like permeate the packaging materials to oxidize fats and fatty oils, vitamins, and proteins. Therefore, sometimes nutrition components are decreased to cause foods deterioration such as color fading and discoloration or degradation of flavor and absorption of off-flavor. In the field in which medical products and medicinal products are dealt with, a high standard to the deterioration or degradation is set with respect to the medical products and medicinal products, and the packaging materials having high gas barrier properties are demanded.

Conventionally, the packaging material having aluminum foil or aluminum vapor-deposited film is used as the packaging material having the high gas barrier properties. However, there are many problems in the conventional packaging materials. That is, aluminum in the packaging material is eluted to easily damage an incinerator in a combustion disposal process. In recycling the packaging materials, it is difficult to separate the aluminum component and a resin film or paper which constitutes a substrate. Furthermore, because of the opaque packaging materials, the deterioration or degradation of inside contents cannot sufficiently be confirmed.

Recently, attention is being paid to packaging materials formed by the silicon monoxide vapor-deposited film having both high gas-barrier properties and excellent transparency. As used herein, the term "silicon monoxide vapor-deposited film" shall mean a silica vapor-deposited film, and a value of suffix x in SiOₓ represents the composition thereof is in the range of 1<x<2. Preferably the value of x is set in the range of 1.4<x<1.8 when the barrier properties of the silicon monoxide vapor-deposited film is utilized for the packaging material. The term "transparency" shall mean that, when the silicon monoxide vapor-deposited film is vapor-deposited on a transparent resin film to produce the packaging material, the silicon monoxide vapor-deposited film has no influence on light transmission and packaged contents can clearly be observed.

Usually, a mixture of silicon and silicon dioxide is heated, a silicon monoxide gas sublimated from the mixture is deposited as a silicon monoxide lump on a deposition substrate, and thereby the vapor deposition material which can provide the silicon monoxide vapor-deposited film is produced by performing forming such as pulverizing or grinding the deposited silicon monoxide. Conventionally various proposals are made as the method for producing the vapor deposition materials.

Japanese Patent Application Publication No. 2002-97567 proposes a silicon monoxide vapor deposition material and a production method thereof, which has high bulk density and high hardness properties such that splash phenomenon can be suppressed in vapor-depositing silicon monoxide on the substrate. According to the production method disclosed in Japanese Patent Application Publication No. 2002-97567, a production apparatus includes: a raw material chamber in which the mixture of metallic silicon (Si) and silicon oxide powder whose molar ratio is set at 1:1 while having an average particle size of 10 µm, or alternatively a solid-state silicon monoxide, is heated and vaporized; and a deposition chamber in which a gaseous silicon monoxide is deposited on the deposition substrate, the raw material chamber being kept at a predetermined temperature lower than a sublimation temperature of silicon monoxide, the temperature being raised to sublimate silicon monoxide after a de-gassing process, thereby silicon monoxide is deposited on the deposition substrate.
However, in the silicon monoxide vapor deposition material obtained by the proposed production method, a film deposition rate is slow to worsen productivity in depositing silicon monoxide on the substrate, which increases production costs. Therefore, the cost increase of the material cannot be avoided in the packaging materials having the silicon monoxide vapor-deposited film made of the silicon monoxide vapor deposition material.

Japanese Patent Application Publication No. 2003-246670 proposes a silicon monoxide sintered material and a production method thereof, in which the evaporation residue becomes not more than 4% of a pre-measurement sample weight when thermogravimetry is performed to a sintered sample in a vacuum under a heating temperature of 1300 °C and a pressure not more than 10 Pa. During the production of the silicon monoxide sintered materials, in order to increase the film deposition rate, the sintering is performed to the silicon monoxide particles of not lower than 250 µm in particle size under a non-oxygen atmosphere after press-forming or while pressing.
In the silicon monoxide sintered materials disclosed in Japanese Patent Application Publication No. 2003-246670, although the film deposition rate can be increased compared with the conventional silicon monoxide vapor deposition materials, the cost reduction is not sufficient as the vapor deposition materials for the packaging materials, and further cost reduction is inevitably demanded.

### Disclosure of the Invention

It is an object of the present invention to provide a silicon monoxide vapor deposition material which increases a film deposition rate when the silicon monoxide having excellent transparency and gas barrier properties is film-formed on the substrate, a raw material silicon powder, and a method for efficiently producing the silicon monoxide.

The present inventors perform various experiments to solve the problem and find that the film deposition rate is largely increased in forming the silicon monoxide vapor-deposited film on the substrate when a hydrogen gas concentration contained in the silicon monoxide vapor deposition material is increased. The present inventors also find that the hydrogen gas content of the raw material metallic silicon powder (silicon-monoxide raw material silicon powder) has a large influence on the hydrogen gas content of the generated silicon monoxide in the silicon monoxide production.

The present invention is completed based on the above finding, and the present invention mainly includes the following (1) to (4) as for a silicon monoxide and an silicon monoxide vapor deposition material, a silicon powder for silicon monoxide raw material, and a method for producing the silicon monoxide:
(1) A silicon monoxide characterized in that a hydrogen gas content is not lower than 120 ppm,
(2) A silicon monoxide vapor deposition material characterized in that a hydrogen gas content is not lower than 120 ppm or not lower than 150 ppm,
(3) A raw material silicon powder for a silicon monoxide
   characterized in that a hydrogen gas content is not lower than 30 ppm, and
(4) A method for producing a silicon monoxide characterized in that a silicon powder and a silicon dioxide powder are mixed together while a hydrogen gas content is not lower than 30 ppm, heated to 1250 °C to 1350 °C, vaporized, and then the silicon monoxide is deposited on a deposition substrate.

According to the silicon monoxide and silicon monoxide vapor deposition material of the present invention, in vapor-depositing silicon monoxide on the substrate, the silicon monoxide film deposition rate can largely be increased to reduce the production cost by increasing the hydrogen gas concentration contained in silicon monoxide and the silicon monoxide vapor deposition material. By raw material silicon powders of the present invention, the silicon monoxide and silicon monoxide vapor deposition material having the proper hydrogen gas content can efficiently be produced.
However, in the above description, the silicon monoxide and silicon monoxide vapor deposition material of the present invention are applied to the packaging materials having transparency and barrier properties which are used in the fields of foods, medical products, medicinal products, and the like, the silicon monoxide and silicon monoxide vapor deposition material of the present invention can also be applied to the lithium battery electrode material (for example, negative electrode of secondary battery).

### Brief Description of the Drawings

Fig. 1 shows a configuration example of a production apparatus used in a method for producing a silicon monoxide powder of the present invention; and
Fig. 2 shows a relationship between a hydrogen gas content in a silicon monoxide vapor deposition material and a sublimation rate of silicon monoxide.

### Best Mode for Carrying out the Invention

The silicon monoxide and silicon monoxide vapor deposition material, the raw material silicon powder for the silicon monoxide, and the silicon monoxide producing method according to the present invention will be described below.

As shown in Example (for example, Table 1) described hereinafter, with reference to a relationship between the hydrogen gas content and the film deposition rate in vapor-depositing the silicon monoxide or silicon monoxide vapor deposition material on the substrate, usually the film deposition rate can be enhanced as the hydrogen gas concentration is increased. That is, in the conventional silicon monoxide vapor deposition material, the film deposition rate is up to 180 Å/sec at most because the hydrogen gas content ranges from about 50 to about 120 ppm. On the other hand, in the silicon monoxide of the present invention, the film deposition rate can be increased to 210 Å/sec by setting the hydrogen gas content to 120 ppm, and further, the film deposition rate can remarkably be increased to 780 Å/sec by setting the hydrogen gas content to 220 ppm which is approximately three times more than that of the conventional silicon monoxide vapor deposition material.

At this point, when the silicon monoxide vapor deposition material is vapor-deposited on the substrate, the film deposition rate is shown as a film thickness value deposited per one second when a sample measuring 19 mm in diameter and 20 mm in length, prepared from the deposited silicon monoxide, is irradiated by an ion plating apparatus having an EB output of 300W for 60 seconds under an initial pressure 4×10⁻⁴ Pa.

For the hydrogen gas content of silicon powder to be the raw material, the hydrogen gas content is lower than about 10 to about 30 ppm in the conventional silicon powder, while the silicon powder having the hydrogen gas content of not lower than 30 ppm can be adopted as the raw material silicon powder of the present invention.
In other words, when the silicon monoxide or silicon monoxide vapor deposition material is produced with the raw material silicon powder having the hydrogen gas content of not lower than 30 ppm, the hydrogen gas content of silicon monoxide can be enhanced to 120 ppm or more after the production. In this case, in order to produce the homogeneous silicon monoxide or silicon monoxide vapor deposition material, desirably the hydrogen gas content is set to 50 ppm or more in the raw material silicon powder.

The present invention is not particularly limited to a particle size of the raw material silicon powder, and the particle size in general use may be adopted in the raw material silicon powder. Desirably the average particle size ranges from 1 to 40 µm. When the raw material silicon powder is reduced to a fine powder, in performing heat treatment for the raw material silicon powder in the hydrogen gas-containing inert gas atmosphere, a variation in concentration of the hydrogen gas is suppressed in the powders and a treatment time can effectively be shortened.

The hydrogen gas content of silicon monoxide or the silicon powder by the present invention is measured at a heating rate of 0.5 °C/sec with a temperature-programmed desorption gas analysis apparatus (TDS) by a mass fragment method.

In the hydrogen gas-containing silicon monoxide of the present invention, the hydrogen gas-containing silicon powder and the silicon dioxide powder which become the raw material of the hydrogen gas-containing silicon monoxide are mixed together at a molar ratio of 1:1, and the raw material which is dried after mixing and granulation is loaded in a raw material vessel of the production apparatus. Then, the raw material is heated and sublimated in an inert gas atmosphere or in a vacuum, the gaseous silicon monoxide is deposited on the deposition substrate, and the obtained deposited silicon monoxide is shaped by cutting and grinding to produce the hydrogen gas-containing silicon monoxide.

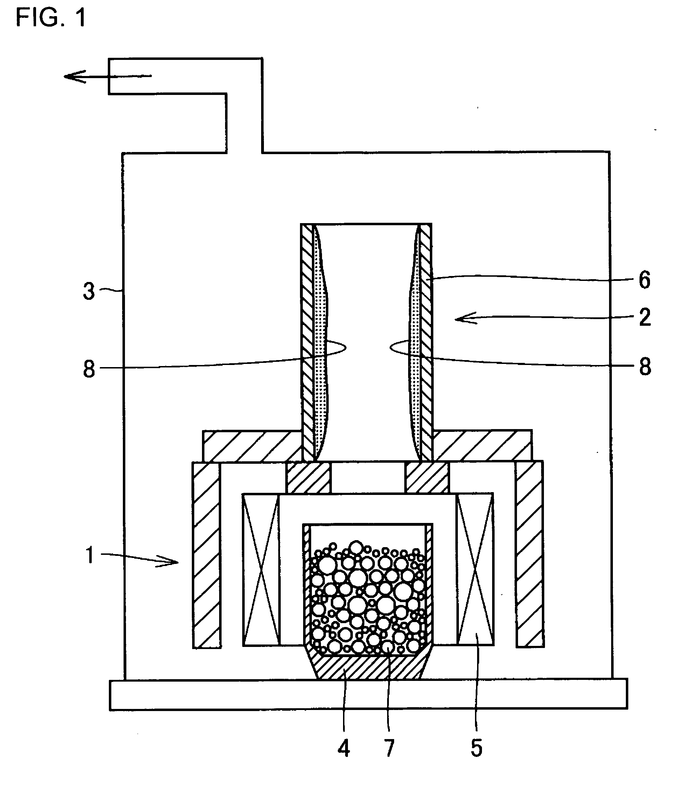

Fig. 1 shows a configuration example of the production apparatus used to produce silicon monoxide of the present invention. In the configuration of the production apparatus, a deposition chamber 2 is placed on a raw material chamber 1, and the deposition chamber 2 and the raw material chamber 1 are installed in a vacuum chamber 3. In the raw material chamber 1, a cylindrical raw material vessel 4 is placed in the center of the cylindrical body, and a heat source 5 formed by an electric heater is arranged around the raw material vessel 4. A vacuum device (not shown) is provided in the vacuum chamber 3, and evacuates the inside gas to a vacuum in an arrow direction of Fig. 1.
A stainless steel deposition substrate 6 is provided in the deposition chamber 2, and the gaseous silicon monoxide sublimated in the raw material chamber 1 is vapor-deposited on an inner peripheral surface of the cylindrical deposition substrate 6.

In the production apparatus shown in Fig. 1, raw materials (hereinafter referred to as "mixed granulation raw material") 7 in which the hydrogen gas-containing silicon powder or silicon fine powder and the silicon dioxide powder are mixed and granulated are loaded in the raw material vessel 4, the raw material vessel 4 is heated in the inert gas atmosphere or in a vacuum, and the silicon monoxide is generated and sublimated by reaction. The generated gaseous silicon monoxide rises from the raw material chamber 1 into the deposition chamber 2, and the gaseous silicon monoxide is vapor-deposited on the inner peripheral surface of the deposition substrate 6 to form the deposited silicon monoxide 8. Then, the deposited silicon monoxide 8 is taken out from the apparatus, and the deposited silicon monoxide 8 is shaped to form silicon monoxide or the silicon monoxide vapor deposition material.
A level of vacuum in the production apparatus is not particularly limited, but the condition usually employed in producing the silicon monoxide vapor deposition material may be adopted.

With reference to the conditions of the temperature increase, heating, and sublimation, as with the usual silicon monoxide production conditions, the mixed granulation raw material 7 loaded in the raw material vessel 4 of the production apparatus is heated from room temperature to a temperature ranging from 800 to 1200 °C and kept at the temperature for at least two hours in order to dry and degas the mixed granulation raw material 7. Then, the mixed granulation raw material 7 is heated to a temperature ranging from 1250 to 1350 °C and vaporized, i.e., sublimated, and the gaseous silicon monoxide is maintained at a temperature ranging from 200 to 600 °C and deposited on the inner peripheral surface of the deposition substrate 6.
The deposited silicon monoxide obtained in the above manner contains the hydrogen gas ranging from 120 ppm to 1% (10000 ppm).

In the production method by the present invention, the silicon monoxide whose hydrogen gas content is not lower than 120 ppm can be obtained by heating and vaporizing the mixed granulation raw material 7 including the silicon powder and the silicon dioxide powder, either hydrogen gas content of which is not lower than 30 ppm. According to the production method by the present invention, the hydrogen gas content of the obtained silicon monoxide is higher than that of the raw material silicon powder. This is because the hydrogen gas contained in the silicon powder is significantly detained due to a strong bonding strength of silicon with hydrogen. As described above, the hydrogen gas content of the silicon powder and the hydrogen gas content of the obtained silicon monoxide can be measured with the temperature-programmed desorption gas analysis apparatus (TDS).

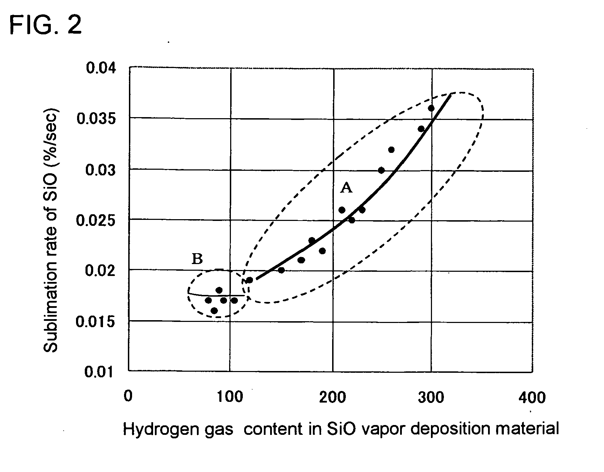

Fig. 2 shows a relationship between the hydrogen gas content in the silicon monoxide vapor deposition material and the sublimation rate of silicon monoxide. As shown in Fig. 2, in the case where the hydrogen gas content of the silicon monoxide is not lower than 120 ppm (portion A surrounded by a dotted line), the sublimation rate of the silicon monoxide becomes faster than the silicon monoxide (portion B surrounded by a dotted line) having the conventional hydrogen gas content.
Particularly, the sublimation rate is remarkably increased when the hydrogen gas content of the silicon monoxide is not lower than 150 ppm.

The sublimation rate of the silicon monoxide of Fig. 2 is shown as a percent loss in weight (%) per one second, which is measured with a differential thermal balance as follows. That is, a 0.5g sample is taken from a lump of the silicon monoxide deposited on the deposition substrate, the sample is heated from the room temperature to 1200 °C at the temperature increase rate of 20 °C/min under the pressure condition of 1 Pa, the sample is further heated to 1300 °C at the temperature increase rate of 10 °C/min, and the sample is kept at 1300 °C for three hours to sublimate the silicon monoxide.

As is clear from the relationship shown in Fig. 2, in the conventional silicon monoxide vapor deposition material, the hydrogen gas ranges from 60 ppm to 110 ppm, and the sublimation rate ranges from 0.015 %/sec to 0.018 %/sec at most. On the contrary, in the silicon monoxide by the present invention, the hydrogen gas content is not lower than 120 ppm, and the sublimation rate of not lower than 0.019 %/sec can be secured.
As described above, when the hydrogen gas content is set to 150 ppm or more, the sublimation rate can remarkably be increased. For example, when the hydrogen gas content is set to about 250 ppm, the sublimation rate becomes about 0.030 %/sec which is double that of the conventional silicon monoxide.

The hydrogen gas-containing raw material silicon powder by the present invention is obtained as follows. A high-purity silicon wafer is mechanically broken and further ground with a ball mill or the like, and the silicon powder is adjusted in size by a sieve. Then, in the inert gas atmosphere containing at least 1% hydrogen gas, the heat treatment is performed for the silicon powder at a temperature of not lower than 500 °C for at least three hours to obtain the hydrogen gas-containing raw material silicon powder. The hydrogen gas content can be controlled by the hydrogen gas content in the inert gas, heating temperature, and treatment time.

Thus, the hydrogen gas-containing silicon monoxide, raw material silicon powder, and silicon monoxide producing method of the present invention are described. Alternatively, a hydrogen gas-containing silicon dioxide powder producing method may be used as another method for producing the silicon monoxide. And, a method for having the hydrogen gas contained in silicon may also be used wherein silicon is included in the mixed granulation raw material which is of the raw material of the conventional silicon monoxide vapor deposition material.
A method of using the conventional mixed granulation raw material to contain the hydrogen gas during a silicon monoxide production process may be used as another method for producing the silicon monoxide. That is, the raw material is heated to deposit the silicon monoxide in the inert gas atmosphere containing the hydrogen gas or in the hydrogen gas atmosphere.

### Example

The effect that the silicon monoxide and silicon monoxide vapor deposition material of the present invention exert will be described below by Example.
In an Ar gas atmosphere containing the hydrogen gas, the heat treatment was performed for the silicon powders having the average particle size of 10 µm at a heating temperature of 500 to 600 °C to produce the silicon powders having the different hydrogen gas contents.
The obtained silicon powders and the silicon dioxide powders were mixed and granulated to form the mixed granulation raw materials, and the mixed granulation raw materials loaded in the raw material vessel was heated to the temperature of 1250 to 1350 °C and sublimated to deposit the silicon monoxide on the deposition substrate employing the silicon monoxide production apparatus shown in Fig. 1. The silicon monoxide samples having the different hydrogen gas contents were produced from the deposited silicon monoxide, and the obtained silicon monoxide was shaped by breaking, grinding or the like to form the silicon monoxide vapor deposition material samples.

Five kinds of silicon monoxide vapor deposition materials (Inventive Examples: three kinds, Comparative Examples: two kinds) were prepared as the samples, the samples were vapor-deposited on the resin film by employing the ion plating apparatus, and the film deposition rate (Å/sec) of the sample were measured. As described above, the film deposition rate was measured as the film thickness deposited per one second when the sample was irradiated by employing the ion plating apparatus having the EB output of 300W for 60 seconds under the initial pressure 4×10⁻⁴ Pa.

Table 1 shows a relationship between the hydrogen gas content in the silicon monoxide vapor deposition material and the measured film deposition rate. As can be seen from the result of Table 1, the film deposition rate of the silicon monoxide onto the resin film is increased compared with the hydrogen gas content (70 ppm and 110 ppm) of the silicon monoxide of Comparative Examples when the hydrogen gas content is set to 120 ppm or more in Inventive Example, and the film deposition rate is also remarkably increased as the hydrogen gas content is increased in Inventive Example.

[Table 1]

**Table 1**

| Segment | Hydrogen gas content of silicon vapor deposition material (ppm) | Film deposition rate (Å/sec) |
|---|---|---|
| Comparative Example | 70 | 180 |
| | 110 | 180 |
| Inventive Example | 120 | 210 |
| | 170 | 560 |
| | 220 | 780 |

### Industrial Applicability

According to the silicon monoxide and silicon monoxide vapor deposition material of the present invention, the film deposition rate is increased by containing the high-concentration hydrogen gas when the silicon monoxide is vapor-deposited on the substrate, so that the silicon monoxide vapor-deposited film can efficiently be formed. In producing the silicon monoxide or silicon monoxide vapor deposition material, the sublimation rate can be increased using the raw material silicon powders of the present invention containing the hydrogen gas, so that the silicon monoxide can efficiently be produced at low costs. Therefore, the silicon monoxide producing method by the present invention can widely be applied as the method for producing the vapor deposition materials for the packaging materials having transparency and barrier properties which are used for foods, medical products, medicinal products, and the like or the vapor deposition materials for the lithium battery electrode materials having silicon monoxide deposited films.

## Claims

1. A silicon monoxide, **characterized in that** a hydrogen gas content is not lower than 120 ppm.

2. A silicon monoxide vapor deposition material, **characterized in that** a hydrogen gas content is not lower than 120 ppm.

3. A silicon monoxide vapor deposition material, **characterized in that** a hydrogen gas content is not lower than 150 ppm.

4. A raw material silicon powder for silicon monoxide, **characterized in that** a hydrogen gas content is not lower than 30 ppm.

5. A method for producing a silicon monoxide, **characterized in that** a silicon powder and a silicon dioxide powder are mixed together while a hydrogen gas content is not lower than 30 ppm, the silicon powder and the silicon dioxide powder are heated to 1250 °C to 1350 °C and vaporized, and the silicon monoxide is deposited on a deposition substrate.
